**Europäisches Patentamt**

(19) **European Patent Office**

**Office européen des brevets**

(11) Veröffentlichungsnummer: **0 221 319**
**B1**

(12) **EUROPÄISCHE PATENTSCHRIFT**

(45) Veröffentlichungstag der Patentschrift:
08.02.89

(51) Int. Cl.⁴: **H01R 9/09**

(21) Anmeldenummer: **86113112.6**

(22) Anmeldetag: **24.09.86**

(54) Anschlussstift für lötfreie Anschlusstechniken.

(30) Priorität: **18.10.85 DE 3537164**

(43) Veröffentlichungstag der Anmeldung:
**13.05.87 Patentblatt 87/20**

(45) Bekanntmachung des Hinweises auf die Patenterteilung:
**08.02.89 Patentblatt 89/6**

(84) Benannte Vertragsstaaten:
**AT BE CH FR GB IT LI LU NL SE**

(56) Entgegenhaltungen:
**EP-A- 0 105 044**
**DE-A- 1 540 251**
**DE-A- 2 741 583**
**DE-A- 2 937 883**
**DE-A- 3 233 652**
**FR-A- 2 239 840**

**IBM TECHNICAL DISCLOSURE BULLETIN, Band 25,
Nr. 6, November 1982, Seiten 3138-3139; F.G. ALLEN et
al.: "Card connector"**

(73) Patentinhaber: **Leonhardy GmbH,
Hersbruckerstrasse 23, D-8561 Reichenschwand(DE)**

(72) Erfinder: **Rolf, Helmut, Jahnstrasse 42,
D-8501 Feucht(DE)**

(74) Vertreter: **Vogel, Georg,
Hermann-Essig-Strasse 35 Postfach 105,
D-7141 Schwieberdingen(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Anschlußstift für lötfreie Anschlußtechniken mit einem in eine durchkontaktierte Bohrung einer Leiterplatte mit Preßsitz einschiebbaren Einpreßabschnitt zur lötfreien elektrischen und mechanischen Verbindung zwischen dem Anschlußstift und der Bohrung der Leiterplatte, bei dem der Einpreßabschnitt mittels einer achsparallelen Einprägung über seinen quadratischen Querschnitt hinaus verformt ist und mindestens zwei einander gegenüberliegende, begrenzt nachgiebige und axial verlaufende Kontaktbahnen bildet.

Um Anschlußstifte für lötfreie Anschlußtechniken lötfrei auch in den Leiterplatten zu befestigen und sie gleichzeitig mit der durchkontaktierten Bohrung zu verbinden, ist es bekannt, solche Anschlußstifte, die üblicherweise einen quadratischen Querschnitt aufweisen, auf einem bestimmten Abschnitt des Schaftes so zu verformen, daß sie in der durchkontaktierten Bohrung mit genormtem Durchmesser mit Preßsitz gehalten sind. Dabei wird der Einpreßabschnitt des Anschlußstiftes durch Eindrücken von ein oder zwei einander gegenüberliegenden Kerben hergestellt, so daß sich über den Schaft hinausreichende Kontaktbahnen bilden, die nach Art eines Kerbstiftes in die Bohrung der Leiterplatte eingedrückt und dort gehalten werden.

Bei einer bekannten Ausgestaltung ist der Einpreßabschnitt zylindrisch ausgebildet und die Einprägung erstreckt sich achsparallel über seine Länge. Die Tiefe und Breite der Einprägung ist dabei größer als der halbe Durchmesser der zylindrischen Außenfläche des Einpreßabschnittes, wie die DE-PS 2 937 883 zeigt.

Nachteilig bei dieser Ausgestaltung ist, daß die Druckverteilung am Umfang des Einpreßabschnittes nach dem Einpressen nicht genau genug beherrschbar ist, auch wenn durch die Einprägung die seitlichen Bereiche des Einpreßabschnittes um die Einprägung begrenzt nachgiebig sind. Es wird wohl ein Einreißen der Leiterplatte im Bereich der Bohrung, wie es bei den starren Einpreßabschnitten gelegentlich der Fall ist, vermieden, dies geht jedoch auf Kosten einer undefinierten Kontaktgabe zwischen dem Einpreßabschnitt und der durchkontaktierten Bohrung der Leiterplatte. Die um die Einprägung verbleibenden Bereiche des Einpreßabschnittes sind nach wie vor in axialer Richtung so starr, daß sie sich in dieser Richtung nicht an Unregelmäßigkeiten und Toleranzen der durchkontaktierten Bohrung anpassen können.

Aus der EP-OS 0 105 044 ist eine Ausgestaltung bekannt, bei der der Einpreßabschnitt durch Trennung in drei Schenkel unterteilt ist, die gegeneinander so ausgelenkt werden, daß eine dreifache axiale Kontaktbahn geschaffen wird. Diese Kontaktbahnen sind zudem wellenförmig ausgebildet, um über die Dicke der Leiterplatte mehrere einzelne Kontaktstellen pro Kontaktbahn zu erhalten.

Dieser bekannte Anschlußstift hat den Nachteil, daß sich beim Einpressen des Einpreßabschnittes in eine durchkontaktierte Bohrung der Leiterplatte die Trennschlitze verlängern und so im Einpreßabschnitt andere Verhältnisse schaffen, die sich in anderen Halte- und Kontaktkräften auswirken. Definierte Halte- und Kontaktkräfte mit engen Toleranzen lassen sich mit dieser Ausgestaltung nicht realisieren.

Es ist Aufgabe der Erfindung, einen Anschlußstift der eingangs erwähnten Art zu schaffen, bei dem der einfach zu prägende Einpreßabschnitt im Bereich seiner Kontaktbahnen eindeutige, reproduzierbare Halte- und Kontaktkräfte über die gesamte Länge des Einpreßabschnittes zu der durchkontaktierten Bohrung der Leiterplatte hin sicherstellt.

Diese Aufgabe wird nach der Erfindung dadurch gelöst, daß die Außenflächen der seitlichen Bereiche und des rückseitigen Bereiches des Einpreßabschnittes um die Einprägung in axialer Richtung wellenförmig mit Wellenbergen und Wellentälern ausgebildet sind, wobei der Abstand der Wellenberge als Kontaktstellen der halben Dicke der Leiterplatte entspricht und daß die Wellenberge des rückseitigen Bereiches mit den Wellentälern der seitlichen Bereiche und die Wellentäler des rückseitigen Bereiches mit den Wellenbergen der seitlichen Bereiche zusammenfallen.

Mit dieser Ausgestaltung werden in allen Kontaktbahnen einzelne, definierte Kontaktstellen geschaffen, die über die Dicke der Leiterplatte verteilt sind. Durch die Versetzung der Wellenberge und Wellentäler in den seitlichen Bereichen und dem rückseitigen Bereich des Einpreßabschnittes um die Einprägung wird erreicht, daß die so gebildeten Kontaktstellen ausreichend weit über den quadratischen Querschnitt des Anschlußstiftes ausgeprägt werden können, ohne daß sich im Bereich des Einpreßabschnittes unerwünschte Spannungen bilden, die zu undefinierten Verhältnissen führen könnten. Im Bereich jeder Kontaktbahn werden zwei Kontaktstellen geschaffen, die mit der durchkontaktierten Bohrung in Verbindung stehen. Trennschlitze im Bereich des Einpreßabschnittes sind vermieden.

Ist nach einer Ausgestaltung vorgesehen, daß die über den Querschnitt des quadratischen Anschlußstiftes hinausreichende Ausprägung der Wellenberge im rückseitigen Bereich kleiner ist als die Ausprägungen der Wellenberge in den seitlichen Bereichen, dann wird die Kontaktgabe und der Halt des Einpreßabschnittes auf zwei einander gegenüberliegende Kontaktbahnen beschränkt, die eine ausreichende Nachgiebigkeit zur Erzielung entsprechend großer Halte- und Kontaktkräfte aufweisen.

Das Einschieben des Einpreßabschnittes in eine durchkontaktierte Bohrung einer Leiterplatte wird nach einer weiteren Ausgestaltung dadurch erleichtert, daß die Wellenberge der seitlichen Bereiche zur Vorder- und Rückseite des Einpreßabschnittes hin abgeschrägt sind.

Eine weitere Verbesserung in dieser Richtung bringt eine Ausgestaltung, die dadurch gekennzeichnet ist, daß die Wellenberge des rückseitigen Bereiches zur Einführseite hin mit einer steilen Flanke und der Einführseite abgekehrt mit einer flach auslaufenden Flanke versehen sind und daß die Wellenberge der seitlichen Bereiche zur Einführseite hin flach auslaufende Flanken und der Einführseite abgekehrt steile Flanken aufweisen.

Damit die einzelnen Kontaktstellen eine individuelle Nachgiebigkeit erhalten, sieht eine Ausgestaltung vor, daß der rückseitige Bereich im Bereich seiner Wellentäler durchgeprägt ist und Durchbrüche zur Einprägung hin aufweist.

Ist nach einer weiteren Ausgestaltung vorgesehen, daß die seitlichen Bereiche des Einpreßabschnittes in axialer Richtung jeweils mindestens vier Wellenberge aufweisen, dann kann der Anschlußstift auch die durchkontaktierten Bohrungen von zwei aufeinander liegenden Leiterplatten elektrisch und mechanisch miteinander verbinden.

Die Erfindung wird anhand von in den Zeichnungen dargestellten Ausführungsbeispielen näher erläutert. Es zeigt:

Fig. 1 in Vorderansicht ein erstes Ausführungsbeispiel eines Einpreßabschnittes eines Anschlußstiftes nach der Erfindung,

Fig. 2 die Ansicht auf die Stirnseite des Anschlußstiftes nach Fig. 1,

Fig. 3 einen Längsschnitt durch den Einpreßabschnitt des Anschlußstiftes nach Fig. 1,

Fig. 4 die Seitenansicht des Anschlußstiftes nach Fig. 1,

Fig. 5 bis 8 die den Fig. 1 bis 4 entsprechenden Darstellungen eines zweiten Ausführungsbeispiels des Einpreßabschnittes eines Anschlußstiftes nach der Erfindung und

Fig. 9 bis 12 die den Fig. 1 bis 4 entsprechenden Darstellungen eines dritten Ausführungsbeispiels des Einpreßabschnittes eines Anschlußstiftes nach der Erfindung.

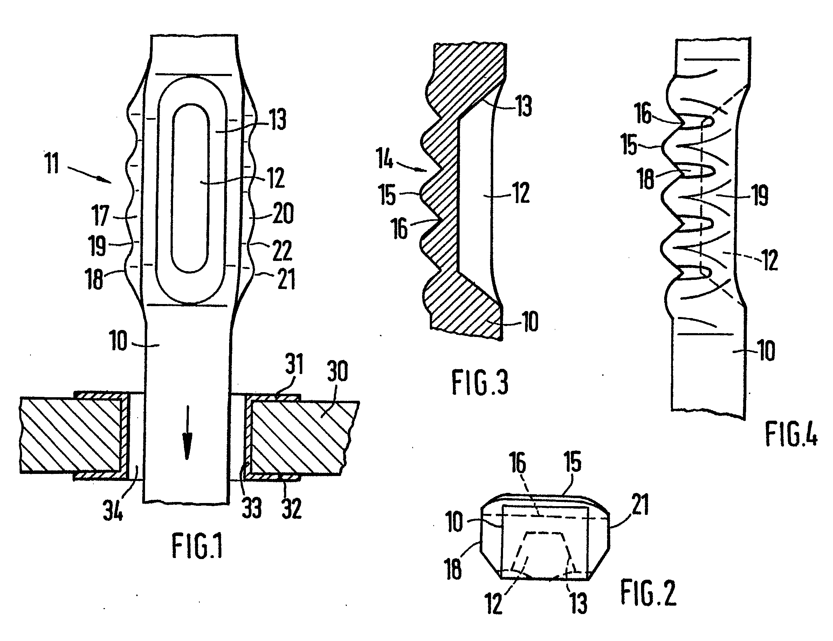

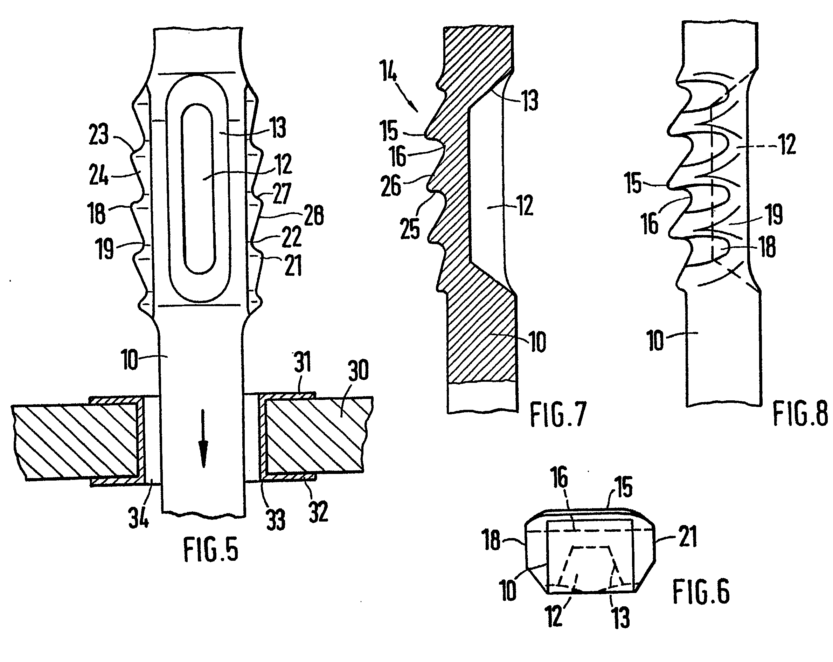

Für den Anschlußstift 10 wird in allen Ausführungsbeispielen Ausgangsmaterial mit einem quadratischen Querschnitt verwendet. Der Einpreßabschnitt 11 erstreckt sich, wie die Fig. 1, 3 und 4 zeigen, über eine axiale Länge, die größer ist als die Dicke von zwei Leiterplatten 30. Die durchkontaktierte Bohrung 33 verbindet Leiterbahnen 31 und 32 auf den beiden Oberseiten der Leiterplatte 30. Die Aufnahme 34 der Bohrung 33 ist rund und im Durchmesser größer als die diagonale Abmessung des Querschnittes des Anschlußstiftes 10. Der Einpreßabschnitt 11 wird durch Verformung gebildet, wobei ein Stempel die Einprägung 12 mit den geneigten Randbereichen 13 bestimmt. Das Gesenk ist so ausgebildet, daß der rückseitige Bereich 14 des Einpreßabschnittes 11 wellenförmig verformt wird, wobei der Abstand der Wellenberge 15 etwa der halben Dicke der Leiterplatte 30 entspricht. Die Wellenberge 15 sind durch die Wellentäler 16 getrennt. Die seitlichen Bereiche des Einpreßabschnittes 11 um die Einprägung 12 herum sind ebenfalls wellenförmig verformt, wie die Wellenberge 18 und 21 und die Wellentäler 19 und 22 zeigen. Das Gesenk ist so ausgelegt, daß in Längsrichtung des Einpreßabschnittes 11 die Wellenberge 15 des rückseitigen Bereiches 14 mit den Wellentälern 19 und 22 der seitlichen Bereiche und die Wellentäler 16 des rückseitigen Bereiches 14 mit den Wellenbergen 18 und 21 der seitlichen Bereiche des Einpreßabschnittes 11 zusammenfallen. Wie die Fig. 2 zeigt, ist die Ausprägung der Wellenberge 15 über den Querschnitt des quadratischen Anschlußstiftes 10 hinaus kleiner als die Ausprägungen der Wellenberge 18 und 21, so daß nur die Wellenberge 18 und 21 beim Einpressen des Einpreßabschnittes 11 in die Aufnahme 34 Kontaktstellen zu der durchkontaktierten Bohrung 33 bilden. Dabei sind über die Länge der durchkontaktierten Bohrung 33 stets zwei Kontaktstellen, d.h. Wellenberge 18 bzw. 21, pro seitlichem Bereich vorgesehen. Die Einprägung 12 ist dabei so tief und breit, daß die seitlichen Bereiche mit den Wellenbergen 18 und 21 ausreichende Nachgiebigkeit besitzen, um sich an die Abmessung der durchkontaktierten Bohrung 33 anpassen zu können. Die Kontaktstellen haben ausreichende Halte- und Kontaktkräfte und können sich individuell an die Unregelmäßigkeiten und Toleranzen der durchkontaktierten Bohrung 33 anpassen. Die Wellenberge 18 und 21 der seitlichen Bereiche des Einpreßabschnittes 11 sind zur Vorder- und Rückseite des Einpreßabschnittes 11 hin abgeschrägt, so daß der Einpreßabschnitt 11 leichter in die durchkontaktierte Bohrung 33 eingedrückt werden kann, wobei nur die mittleren Teile der Wellenberge 18 und 21 flächige Kontaktstellen bilden, wie sie der Ansicht nach Fig. 4 zu entnehmen sind. Die Wellenberge 15 des rückseitigen Bereiches 14 bilden keine Kontaktstellen in der durchkontaktierten Bohrung 33, sie sind so gewählt, daß bei der Verformung des Einpreßabschnittes 11 die Wellenberge 18 und 21 der seitlichen Bereiche diese ausgeprägte Form erhalten können. Wie die Ansicht nach Fig. 1 zeigt, ist die Einprägung 12 an ihren Schmalseiten abgerundet und rings umlaufend mit dem geneigten Randbereich 13 versehen.

Nach der Ausprägung des Einpreßabschnittes 11 stehen die Wellenberge 18 und 21 einander gegenüber an den Außenseiten des Einpreßabschnittes 11 in einem Abstand, der größer ist als der Durchmesser der durchkontaktierten Bohrung 33. Mit den Abmessungen der Einprägung 12 läßt sich die Elastizität und die Nachgiebigkeit der seitlichen Bereiche mit den Wellenbergen 18 und 21 festlegen und damit werden auch die Haltekraft des Einpreßabschnittes 11 in der durchkontaktierten Bohrung 33 und die Kontaktkräfte der durch die Wellenberge 18 und 21 gebildeten Kontaktstellen bestimmt. Beim Einpressen des Einpreßabschnittes 11 in die durchkontaktierte Bohrung 33 kann sich kein Trennschlitz verändern, so daß die durch die Einprägung vorgegebenen Verhältnisse eindeutig und rekonstruierbar die Halte- und Kontaktkräfte festlegen, wobei die einzelnen Kontaktstellen sich individuell an die Gegebenheiten der durchkontaktierten Bohrung 33 anpassen können.

Bei dem Ausführungsbeispiel nach den Fig. 5 bis 8 sind die Verhältnisse ähnlich. Die Wellenberge 15, 18 und 21 sind jedoch der Einführseite hin und der Einführseite abgekehrt mit unterschiedlich ansteigenden Flanken versehen. Bei den Wellenbergen 15 des rückseitigen Bereiches 14 sind die der Einführseite zugekehrten Flanken 25 der Wellenberge 15 steil, während die der Einführseite abgekehrten Flanken 26 flach auslaufen. Damit läßt sich erreichen, daß die der Einführseite zugekehrten Flanken 24 und 28 der Wellenberge 18 und 21 flach ansteigend und die der Einführseite abgekehrten Flanken 23 und 27 der Wellenberge 18 und 21 steil abfallend ausgeprägt werden können. Damit wird das Eindrücken des Einpreßabschnittes 11 in die durchkontaktierte Bohrung 33, verbunden mit einem Nachgeben der seitlichen Bereiche des Einpreßabschnittes 11, wesentlich erleichtert. Dies ist von Vorteil, wenn mehrere Anschlußstifte 10 mit ihren Einpreßabschnitten 11 gleichzeitig in entsprechende durchkontaktierte Bohrungen 33 eingedrückt werden. Da der rückseitige Bereich 14 der Einpreßabschnitte 11 nicht mit der durchkontaktierten Bohrung 33 in Kontakt kommt, beeinträchtigen die der Einführseite zugekehrten steilen Flanken 25 der Wellenberge 15 des rückseitigen Bereiches 14 das Eindrücken des Einführabschnittes 11 in die durchkontaktierte Bohrung 33 nicht.

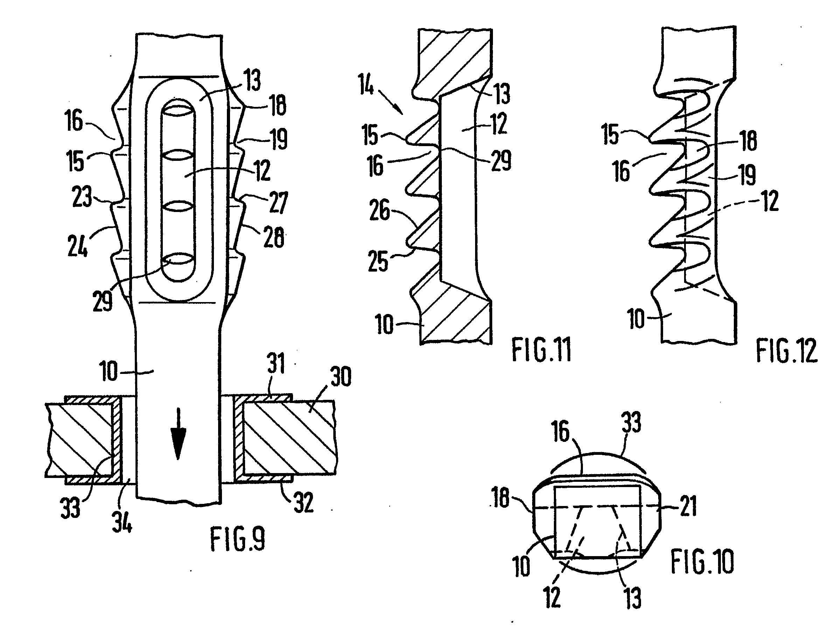

Bei dem Ausführungsbeispiel nach den Fig. 9 bis 12 ist der rückseitige Bereich 14 im Bereich der Wellentäler 16 so weit ausgeprägt, daß an diesen Stellen Durchbrüche 29 im rückseitigen Bereich 14 entstehen. Die Verteilung der Wellenberge 15, 18 und 21 des Einpreßabschnittes 11 ist wie bei dem Ausführungsbeispiel nach den Fig. 5 bis 8. Außerdem sind die Flanken 25 und 26 der Wellenberge 15 und die Flanken 23 und 27 bzw. 24 und 28 der Wellenberge 18 und 21 mit Neigungen versehen, wie sie auch beim Ausführungsbeispiel nach den Fig. 5 bis 8 gewählt sind. Durch die Durchbrüche 29 im rückseitigen Bereich 14 des Einpreßabschnittes 11 wird die individuelle Anpassungsfähigkeit der einzelnen, durch die Wellenberge 18 und 21 gebildeten Kontaktstellen wesentlich verbessert. Die Abschrägung der Wellenberge 18 und 21 zur Vorder- und Rückseite des Einpreßabschnittes 11 hin ist beibehalten, so daß der Einpreßabschnitt 11 leicht in die durchkontaktierte Bohrung 33 eingedrückt werden kann. Fig. 10 zeigt noch einmal, daß der ausgeprägte Einpreßabschnitt 11 mit den Wellenbergen 15 des rückseitigen Bereiches 14 nicht mit der durchkontaktierten Bohrung 33 in Kontakt kommt. Die Wellenberge 18 und 21 sind über den quadratischen Querschnitt des Anschlußstiftes 10 hinaus ausgeprägt, daß der Abstand der Wellenberge 18 und 21 und damit der dadurch gebildeten Kontaktstellen größer ist als der Durchmesser der durchkontaktierten Bohrung 33. Beim Einpressen des Einpreßabschnittes 11 in die durchkontaktierte Bohrung 33 können die seitlichen Bereiche mit den Wellenbergen 18 und 21 so weit nachgeben, daß die Wellenberge 18 und 21 mit ihren mittleren Bereichen unter Spannung an der durchkontaktierten Bohrung 33 anliegen. Diese Spannung erzeugt eine ausreichende mechanische Haltekraft für den Einpreßabschnitt 11 in der durchkontaktierten Bohrung 33 bei ausreichend großer Kontaktkraft der durch die Wellenberge 18 und 21 gebildeten Kontaktstellen. Dabei können sich die Kontaktstellen individuell an die Unregelmäßigkeiten und Toleranzen der durchkontaktierten Bohrung 33 anpassen. Da der Abstand der Wellenberge 18 und 21 der halben Dicke der Leiterplatte 30 entspricht, wird jeder seitliche Bereich des Einpreßabschnittes 11 über zwei Kontaktstellen an der durchkontaktierten Bohrung 33 abgestützt.

## Patentansprüche

1. Anschlußstift (10) für lötfreie Anschlußtechniken mit einem in eine durchkontaktierte Bohrung (33) einer Leiterplatte (30) mit Preßsitz einschiebbaren Einpreßabschnitt (11) zur lötfreien elektrischen und mechanischen Verbindung zwischen dem Anschlußstift (10) und der Bohrung (33) der Leiterplatte (30), bei dem der Einpreßabschnitt (11) mittels einer achsparallelen Einprägung (12) über seinen quadratischen Querschnitt hinaus verformt ist und mindestens zwei einander gegenüberliegende, begrenzt nachgiebige und axial verlaufende Kontaktbahnen bildet, dadurch gekennzeichnet, daß die Außenflächen der seitlichen Bereiche und des rückseitigen Bereiches des Einpreßabschnittes (11) um die Einprägung (12) in axialer Richtung wellenförmig mit Wellenbergen (15, 18, 21) und Wellentälern (16, 19, 22) ausgebildet sind, wobei der Abstand der Wellenberge (15, 18, 21) als Kontaktstellen der halben Dicke der Leiterplatte (30) entspricht und daß die Wellenberge (15) des rückseitigen Bereiches (14) mit den Wellentälern (19, 22) der seitlichen Bereiche und die Wellentäler (16) des rückseitigen Bereiches (14) mit den Wellenbergen (18, 21) der seitlichen Bereiche zusammenfallen.

2. Anschlußstift nach Anspruch 1, dadurch gekennzeichnet, daß die über den Querschnitt des quadratischen Anschlußstiftes (10) hinausreichende Ausprägung der Wellenberge (15) im rückseitigen Bereich (14) kleiner ist als die Ausprägungen der Wellenberge (18, 21) in den seitlichen Bereichen.

3. Anschlußstift nach Anspruch 1 oder 2, dadurch gekennzeichnet, daß die Wellenberge (18, 21) der seitlichen Bereiche zur Vorder- und Rückseite des Einpreßabschnittes (11) hin abgeschrägt sind.

4. Anschlußstift nach einem der Ansprüche 1 bis 3, dadurch gekennzeichnet, daß die Wellenberge (15) des rückseitigen Bereiches (14) zur Einführseite hin mit einer steilen Flanke (25) und der Einführseite abgekehrt mit einer flach auslaufenden Flanke (26) versehen sind und daß die Wellenberge (18, 21) der seitlichen Bereiche zur Einführseite hin flach auslaufende Flanken (24, 28) und der Einführseite abgekehrt steile Flanken (23, 27) aufweisen.

5. Anschlußstift nach einem der Ansprüche 1 bis 4, dadurch gekennzeichnet, daß der rückseitige Bereich (14) im Bereich seiner Wellentäler (16) durchgeprägt ist und Durchbrüche (29) zur Einprägung (12) hin aufweist.

6. Anschlußstift nach einem der Ansprüche 1 bis 5, dadurch gekennzeichnet, daß die seitlichen Bereiche des Einpreßabschnittes (11) in axialer Richtung jeweils mindestens vier Wellenberge (15, 18, 21) aufweisen.

## Claims

1. A connecting pin (10) for solder-less connecting methods comprising a press-in portion (11) which can be pushed with a press fit into a plated-through bore (33) in a circuit board (30), for making a solder-free electrical and mechanical connection between the connecting pin (10) and the bore (33) in the circuit board (30), wherein the press-in portion is deformed beyond its square cross-section by means of an impression (12) in axial-parallel relationship, and forms at least two mutually oppositely disposed, limitedly flexible and axially extending contact tracks, characterised in that the outside surfaces of the lateral regions and the rearward region of the press-in portion (11) around the impression (12) are of a wave-like configuration in the axial direction with wave crests (15, 18, 21) and wave throughs (16, 19, 22), wherein the spacing between the wave crests (15, 18, 21) as contact locations corresponds to half the thickness of the circuit board (30), and that the wave crests (15) of the rearward region (14) coincide with the wave troughs (19, 22) of the lateral regions and the wave troughs (16) of the rearward region (14) coincide with the wave crests (18, 21) of the lateral regions.

2. A connecting pin according to claim 1, characterized in that the outward extent of the wave crests (15) in the rearward region (14), which goes beyond the cross-section of the square connecting pin (10), is smaller than the outward extents of the wave crests (18, 21) in the lateral regions.

3. A connecting pin according to claim 1 or 2, characterised in that the wave crests (18, 21) of the lateral regions slope away to the front and rear of the press-in portion (11).

4. A connecting pin according to one of claims 1 to 3, characterised in that the wave crests (15) of the rearward region (14) are provided with a steep flank (26) with a shallow slope, away from the insertion end, and that the wave crests (18, 21) of the lateral regions have flanks (24, 28) which are of a shallow slope towards the insertion end and steep flanks (23, 27), away from the insertion end.

5. A connecting pin according to one of claims 1 to 4, characterised in that the rearward region (14) is pressed through in the region of its ware troughs (16) and has through apertures (29) towards the impression (12).

6. A connecting pin according to one of claims 1 to 5, characterised in that the lateral regions of the press-in portion (11) each have at least four wave crests (15, 18, 21) in the axial direction.

**Revendications**

1. Broche de connexion pour technique de connexion sans soudure, qui comporte un segment insérable (11) pouvant être emmanché avec ajustage serré dans un trou (33) métallisé d'une plaquette (30) à circuits imprimés, pour relier mécaniquement et électriquement sans soudure cette broche (10) et ce trou (33) de la plaquette (30), et dont ce segment insérable (11) est élargie au moyen d'une empreinte matricée (12) parallèle à son axe, au-delà de sa section carrée, et forme au moins deux zones de contact, opposées et à flexibilité limitée, broche caractérisée en ce que les surfaces extérieures des côtés et du dos du segment insérable (11) sont ondulées dans le sens axial autour de l'empreinte matricée (12), en formant des crêtes ou cannelures (15, 18, 21) et des creux (16, 19, 22), l'écartement des cannelures (15, 18, 21) qui forment des surfaces de contact correspondant à la moitié de l'épaisseur de la plaquette (30) à circuits imprimés, et en ce que les cannelures (15) du dos (14) coincident avec les creux (19, 22) des côtés et les creux (16) de ce dos (14) coincident avec les cannelures (18, 21) de ces côtés.

2. Broche de connexion selon la revendication 1, caractérisée en ce que la hauteur des cannelures (15) du dos (14), par rapport à la section de la broche (10) carrée, est plus faible que la hauteur des cannelures (18, 21) des côtés.

3. Broche de connexion selon la revendication 1 ou 2, caractérisée en ce que les cannelures (18, 21) des côtés sont chanfreinées vers l'avant et vers l'arrière du segment (11) insérable.

4. Broche de connexion selon l'une des revendications 1 à 3, caractérisée en ce que les cannelures (15) du dos (14) présentent un flanc abrupt (25) du côté de l'insertion et un flanc faiblement incliné (26) du côté opposé à l'insertion et en ce que les cannelures (18, 21) des côtés présentent, du côté de l'insertion, des flancs (24, 28) peur inclinés et, du côté opposé à l'insertion, des flancs (23, 27) abruptes.

5. Broche de connexion selon l'une des revendications 1 à 4, caractérisée en ce que le dos (14) est fortement repoussé à l'emplacement des creux (16) et présente des ajours (29) débouchant dans l'empreinte repoussée (12).

6. Broche de connexion selon l'une des revendications 1 à 5, caractérisé en ce que chacun des côtés du segment insérable (11) présente au moins quatre cannelures (15, 18, 21) dans le sens axial.

FIG.1

FIG.3

FIG.4

FIG.2

EP 0 221 319 B1

FIG.5

FIG.6

FIG.7

FIG.8

EP 0 221 319 B1

FIG.9

FIG.11

FIG.12

FIG.10

EP 0 221 319 B1